# FASCICULE DE BREVET EUROPEEN

(11) **EP 2 405 538 B1**
(45) Date de publication et mention de la délivrance du brevet: **28.06.2017**
(21) Numéro de dépôt: 11172592.5
(22) Date de dépôt: 04.07.2011
(51) Int. Cl.: H01R 13/658, H01R 12/52, H01R 12/70, H05K 3/36, H01R 107/00, H01R 13/7195

(54) **Connecteur d'ensembles électroniques blindant et sans soudure électrique**
Abschirmender Schutzanschluss von Elektronikeinheiten ohne elektrische Verschweißung
Shielding connector without electrical welding for electronic assemblies

(30) Priorité: 06.07.2010 FR 1002836
(43) Date de publication de la demande: 11.01.2012
(73) Titulaire: Thales, 92400 Courbevoie (FR)
(72) Inventeur: Courselle, Laurent, 31300 TOULOUSE (FR); Tonus, Serge, 31490 LEGUEVIN (FR); Frinault, Céline, 31320 CASTANET TOLOSAN (FR); Debarge-Caille, Cécile, 31100 TOULOUSE (FR); Riad, Abdelmounaim, 31620 VILLAUDRIC (FR); Monfraix, Philippe, 31320 CASTANET TPMPSA (FR)
(74) Mandataire: Henriot, Marie-Pierre

(56) Documents cités:
- EP-A2- 1 950 849
- WO-A1-01/57967
- FR-A1- 2 801 433
- US-A1- 2007 184 681
- US-A1- 2008 139 017

## Description

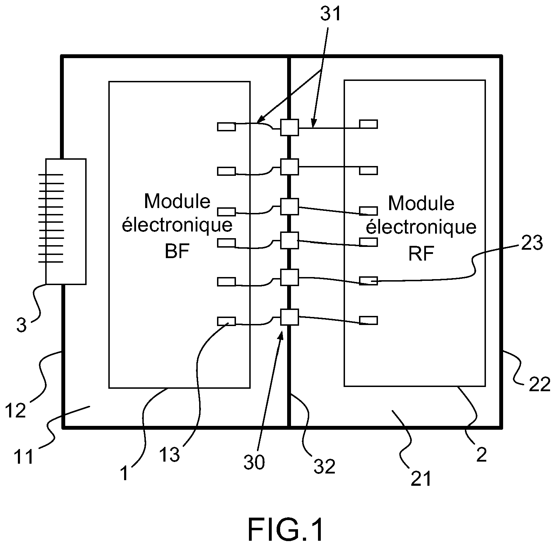

Le domaine de l'invention est celui de l'interconnexion de deux cartes électroniques d'un équipement actif RF, comme ceux qui sont embarqués à bord de la charge utile d'un satellite. Ces cartes sont placées chacune dans une cavité et il est nécessaire d'assurer le blindage de ces cavités afin de prévenir les interférences électromagnétiques d'une carte à l'autre. US-2007 184681 et US-2008 139017 divulguent un dispositif d'interconnection de cartes électroniques. Pour obtenir un cloisonnement rigoureux des différentes fonctions électroniques internes à un équipement actif RF (Radio Fréquence), un objectif de blindage de l'ordre de 90 dBi pour des fréquences supérieures à 1 GHz, est visé. La solution la plus couramment mise en oeuvre dont un exemple est représenté figure 1, consiste à réaliser cette interconnexion électrique au moyen de traversées filtrantes. Chaque carte (ou module) électronique ( un module 1 BF (Basse Fréquence) et un module 2 RF dans cet exemple) est fixée dans une cavité délimitée par une structure à cloisons métalliques. Des traversées filtrantes 30 aussi désignées traversées capacitives, sont reportées par collage dans des ouvertures pratiquées dans une cloison 32 commune aux deux cavités 11 et 21. Ces traversées filtrantes 30 sont munies de joints RF. Les plages de connexion 13, 23 des cartes électroniques sont reliées aux traversées 30 par des fils électriques 31 qui sont soudés à leurs deux extrémités. Chaque traversée filtrante 30 permet d'assurer la connexion électrique d'un signal ; il faut donc autant de traversées filtrantes que de signaux à faire passer d'une carte à l'autre. La capacité et le joint RF de chaque traversée 30 assure entre les deux cartes, une isolation EMC acronyme de l'expression anglo-saxonne « ElectroMagnetic Compatibility ». L'élément 3 est un connecteur d'alimentation qui sert d'interface avec l'extérieur et qui ramène donc les signaux BF générés à l'extérieur de l'équipement qui doivent transiter par le module BF 1 (dans lequel ils sont retraités) et au final alimenter le module RF 2 une fois retraités.

Ces traversées filtrantes nécessitent donc des opérations de collage et de câblage manuelles pour effectuer les liaisons électriques inter modules. L'exigence de blindage RF complexifie l'agencement des modules électroniques et donc le design des structures mécaniques les hébergeant. Finalement, sans compter le coût induit sur la structure, le coût unitaire d'une traversée filtrante équipée d'un joint RF est d'environ 100 € auquel il faut ajouter environ 150 € de main d'oeuvre.

Ces opérations manuelles sont en outre multipliées par le nombre de signaux à faire passer (il faut N traversées pour faire passer N signaux), qui s'accroît de plus en plus. Il existe en effet un besoin croissant d'équipements munis de modules électroniques à forte valeur ajoutée, qui regroupent plusieurs fonctions sur un même substrat.

Et il est impossible de faire passer des signaux rapides à cause du filtrage sur les traversées.

Le but de l'invention est de pallier ces inconvénients. En conséquence, il demeure à ce jour un besoin pour un dispositif d'interconnexion donnant simultanément satisfaction à l'ensemble des exigences précitées, notamment en termes de coût unitaire, de coût de main d'oeuvre, de blindage, de capacité de signaux à faire passer.

Plus précisément l'invention a pour objet un dispositif d'interconnexion de deux cartes électroniques comportant chacune des plages de connexion électrique, chaque carte étant destinée à être placée dans une cavité blindée différente. Ce dispositif comprend des moyens de blindage hyperfréquence inter cavité et il est principalement caractérisé en ce qu'il comprend :
- plusieurs conducteurs électriques traversant le dispositif de part en part, sans soudure, dont les deux extrémités sont respectivement destinées à être en contact direct avec les plages de connexion des deux cartes électroniques,
- des moyens mécaniques de maintien des deux cartes électroniques contre le dispositif, de part et d'autre de celui-ci,
- et en ce que les moyens de blindage sont assurés par un absorbant hyperfréquence au contact de chaque conducteur et l'entourant sur tout ou partie de sa longueur.

Ce dispositif d'inter connexion BF offre à la fois une solution aux problèmes de blindage RF inter cavité dans un équipement actif d'une charge utile et une simplification des interconnexions internes entre deux sous-ensembles électroniques (carte, boîtier...). Ce dispositif permet également d'optimiser les designs mécaniques des structures d'équipement qui y sont associées et va dans le sens d'une réduction des coûts du fait notamment de la suppression des traversées filtrantes et des connexions par soudure associées.

De préférence, chaque conducteur électrique comporte entre ses deux extrémités des moyens de pression de ses extrémités vers l'extérieur du dispositif, de manière à renforcer le contact électrique avec les plages de connexion.

Ces moyens de pression sont par exemple un ou deux ressorts mécaniques ou aimants électriquement conducteurs placés entre les extrémités.

Les moyens mécaniques de maintien des deux cartes électroniques peuvent comporter une (ou plusieurs) tige(s) filetée(s) avec écrous ou une (ou plusieurs) vis.

Il comporte avantageusement sur une face destinée à être en contact avec une paroi délimitant les cavités, un joint d'étanchéité électromagnétique disposé dans une gorge du dispositif, de préférence amovible.

Selon une caractéristique de l'invention, il comporte une résine de maintien des conducteurs dans le dispositif.

Selon une autre caractéristique de l'invention, l'absorbant hyperfréquence est efficace pour des fréquences supérieures à 1 GHz.

D'autres caractéristiques et avantages de l'invention apparaîtront à la lecture de la description détaillée qui suit, faite à titre d'exemple non limitatif et en référence aux dessins annexés dans lesquels :
la figure 1 déjà décrite représente schématiquement un exemple de dispositif d'interconnexion selon l'état de la technique,
les figures 2 représentent schématiquement des vues en coupe d'un exemple de dispositif d'interconnexion selon l'invention, (installé entre deux cavités (fig 2a), vu plus en détail (fig 2b)),
les figures 3 représentent schématiquement des vues en perspective (fig 3a), de dessus (fig 3b) et de dessous (fig 3c) d'un exemple de dispositif d'interconnexion selon l'invention, de forme circulaire, à 8 fûts conducteurs.

D'une figure à l'autre, les mêmes éléments sont repérés par les mêmes références.

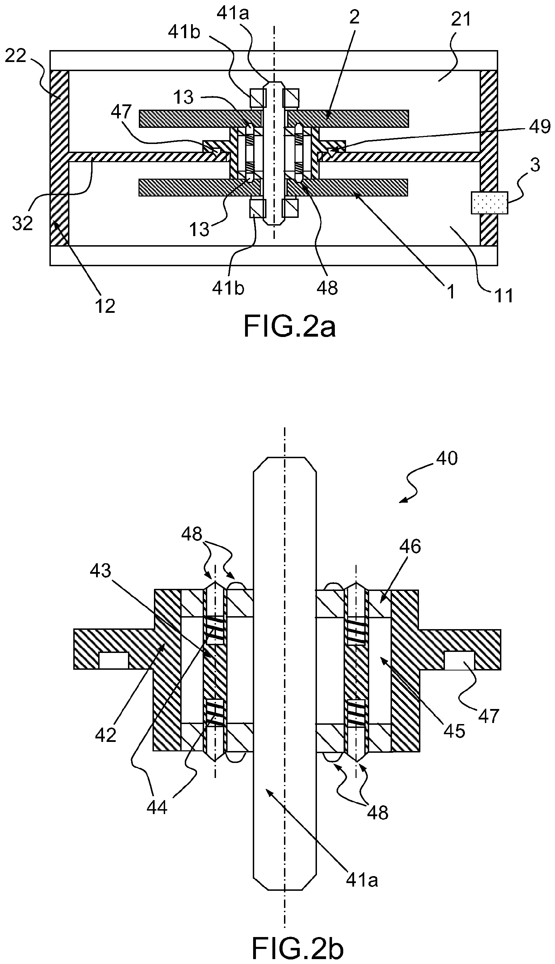

On décrit en relation avec les figures 2 un dispositif d'interconnexion de deux cartes électroniques, une carte BF 1 et une carte RF 2, comportant chacune des plages 13 de connexion électrique. Elles sont respectivement placées dans deux cavités 11, 21 à cloisons métalliques. Les cartes électroniques destinées à être connectées sont par exemple :
- deux circuits imprimés,
- un circuit imprimé et un circuit macro-hybride (un macrohybride étant un boîtier fermé hermétiquement dans lequel un circuit électronique est intégré. C'est l'équivalent de la carte RF 2 en figure 1 dans notre exemple)
- deux cartes en céramiques.

Le dispositif d'interconnexion 40 comprend une structure métallique ou corps 42 et des moyens mécaniques de maintien des deux cartes électroniques contre le dispositif, de part et d'autre de celui-ci. Il s'agit par exemple de moyens de maintien provisoire tels qu'une tige filetée 41a (ou plusieurs) associée à des écrous 41 b comme montré sur la figure. Les cartes pourraient aussi être maintenues par une vis (ou plusieurs). Ils peuvent être disposés au centre du dispositif ou en tout autre emplacement (périphérie, ...).

Il comprend également plusieurs conducteurs électriques 48 aussi désignés fûts conducteurs qui traversent le dispositif de part en part, sans soudure ; les deux extrémités de chaque fût conducteur sont respectivement destinées à être en contact direct avec les plages de connexion 13 des deux cartes électroniques maintenues de part et d'autre du dispositif d'interconnexion comme indiqué ci-dessus. Il n'y a plus de fils électriques à souder. Ces fûts conducteurs 48 sont maintenus dans le dispositif au moyen par exemple d'une résine 46 qui les enserre sur une partie de leur longueur ; sur l'exemple de la figure, la résine 46 les enserre au niveau de leurs extrémités ; elle est en outre électriquement isolante de manière à isoler les extrémités des conducteurs 48 entre elles.

Selon une variante privilégiée de l'invention, chaque conducteur électrique 48 comporte entre ses deux extrémités, des moyens de pression 44 des extrémités vers les plages de connexion. Ils permettent de plaquer les extrémités sur les plages de connexion 13 et ainsi d'assurer la connexion électrique même en présence de fortes vibrations, ce qui est généralement le cas pour un équipement embarqué à bord de la charge utile d'un satellite. Ces moyens de pression électriquement conducteurs sont par exemple un (ou deux) ressort(s), comme montré sur la figure. On peut aussi prévoir un ou deux aimants.

Le blindage RF entre cavités est assuré par un absorbant hyperfréquence 45 qui est au contact de chaque conducteur 48 et l'entoure sur toute sa longueur ou une partie de sa longueur. Sur l'exemple de la figure, l'absorbant 45 entoure chaque fût sur sa partie centrale. Cet absorbant 45 est typiquement une résine absorbante en époxy chargée avec des particules d'acier.

De préférence un joint d'étanchéité EMC 49 éventuellement amovible, est disposé sur une face du dispositif en contact avec la paroi 32 délimitant les deux cavités. Ce joint 49 qui est par exemple un joint de silicone avec des particules de cuivre et d'argent, a pour fonction d'assurer le blindage entre le corps 42 du dispositif de connexion et la paroi sur laquelle il est implanté. Ce joint est avantageusement placé dans une gorge 47 pratiquée dans le corps 42 du dispositif prévue à cet effet.

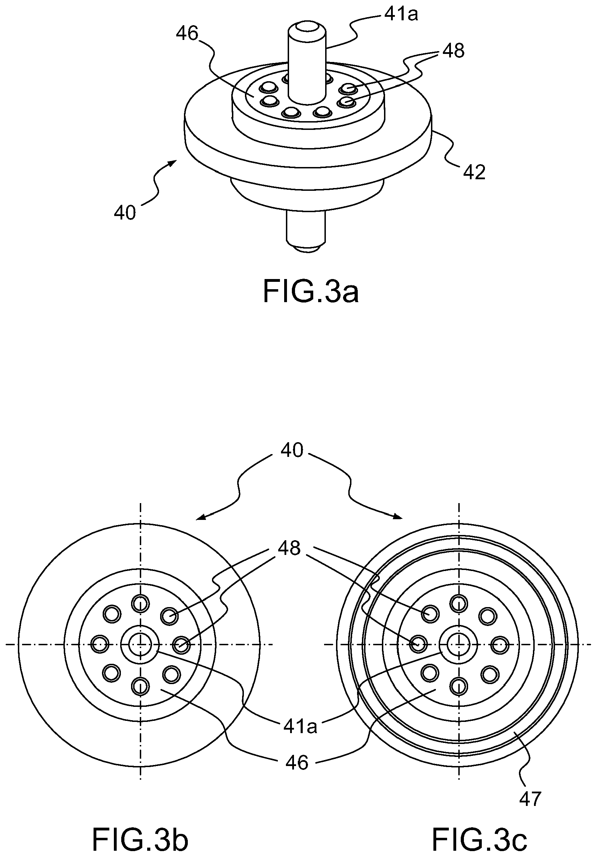

Le dispositif d'interconnexion 40 peut avoir une forme circulaire comme montré sur les figures, mais différentes géométries peuvent se concevoir de manière à s'adapter à la disposition des plages de connexion sur les cartes électroniques. Ainsi par exemple, à un dispositif d'inter connexion tel que représenté figures 3, correspondent des cartes électroniques avec des plages de connexion (8 sur l'exemple de la figure 3) également disposées en cercle.

L'exemple de dispositif de connexion selon l'invention présenté sur les figures, a typiquement les dimensions suivantes :
- diamètre extérieur :160 mm,
- épaisseur du corps métallique : 6 mm,
- longueur de la tige filetée : 160 mm.

Un dispositif d'interconnexion selon l'invention présente les avantages suivants :
- Suppression des traverses filtrantes ainsi que des opérations manuelles de collage et câblage qui leurs sont associées.
- Simplification du design mécanique des structures porteuses : moins de cloisons, suppression des perçages avec renvoi d'angle. Possibilité aussi d'agencement des sous-ensembles plus optimisés et procurant un gain de place.
- Il peut répondre à un besoin croissant de réalisation de sous-ensembles à forte valeur ajoutée (exemple : cartes glob-top) où l'essentiel des signaux transite par un seul connecteur puisqu'on peut faire passer autant de signaux que de conducteurs. Cela permet de diminuer les coûts de regroupement.
- Il permet de faire passer des signaux d'alimentation bus secondaire ainsi que des signaux de commandes sans les déformer car il ne filtre pas les signaux pour des fréquences F inférieures à 1 GHz.

## Revendications

1. Dispositif d'interconnexion (40) de deux cartes électroniques (1, 2) comportant chacune des plages (13) de connexion électrique, chaque carte étant destinée à être placée dans une cavité blindée différente (11, 21), ce dispositif comprenant des moyens de blindage hyperfréquence inter cavité, **caractérisé en ce qu'**il comprend en outre :
- plusieurs conducteurs électriques (48) traversant le dispositif de part en part, sans soudure, dont les deux extrémités sont respectivement destinées à être en contact direct avec les plages de connexion (13) des deux cartes électroniques,
- des moyens mécaniques de maintien des deux cartes électroniques contre le dispositif, de part et d'autre de celui-ci,
- et **en ce que** les moyens de blindage sont assurés par un absorbant hyperfréquence (45) au contact de chaque conducteur (48) et l'entourant sur tout ou partie de sa longueur.

2. Dispositif d'interconnexion (40) de deux cartes électroniques selon la revendication précédente, **caractérisé en ce que** chaque conducteur électrique (48) comporte entre ses deux extrémités des moyens de pression de ses extrémités vers l'extérieur du dispositif, de manière à renforcer le contact électrique avec les plages de connexion.

3. Dispositif d'interconnexion (40) de deux cartes électroniques selon la revendication précédente, **caractérisé en ce que** ces moyens de pression sont un ou deux ressorts mécaniques (44) ou aimants, électriquement conducteurs placés entre les extrémités.

4. Dispositif d'interconnexion (40) de deux cartes électroniques selon l'une des revendications précédentes, **caractérisé en ce que** les moyens mécaniques de maintien des deux cartes électroniques comportent une (ou plusieurs) tige(s) filetée(s) (41a) avec écrous (41b) ou une (ou plusieurs) vis.

5. Dispositif d'interconnexion (40) de deux cartes électroniques selon l'une des revendications précédentes, **caractérisé en ce qu'**il comporte sur une face destinée à être en contact avec une paroi (32) délimitant les cavités, un joint d'étanchéité électromagnétique (49) disposé dans une gorge du dispositif (47), de préférence amovible.

6. Dispositif d'interconnexion (40) de deux cartes électroniques selon l'une des revendications précédentes, **caractérisé en ce qu'**il comporte une résine (46) de maintien des conducteurs dans le dispositif.

7. Dispositif d'interconnexion (40) de deux cartes électroniques selon l'une des revendications précédentes, **caractérisé en ce que** l'absorbant hyperfréquence (45) est absorbant pour des fréquences supérieures à 1 GHz.

8. Equipement actif RF qui comprend :
- deux cavités blindées (11, 21) comportant une cloison commune (32),
- deux cartes électroniques (1, 2), chaque carte étant placée dans une cavité blindée différente, et
- un dispositif d'interconnexion (40) des deux cartes électroniques selon l'une des revendications précédentes, installé entre les deux cavités dans la cloison commune.

## Patentansprüche

1. Vorrichtung (40) zum Verbinden von zwei elektronischen Karten (1, 2) miteinander, die jeweils elektrische Anschlussbereiche (13) haben, wobei jede Karte zum Platzieren in einem anderen abgeschirmten Hohlraum (11, 21) bestimmt ist, wobei diese Vorrichtung Mittel zur Mikrowellenabschirmung zwischen den Hohlräumen umfasst, **dadurch gekennzeichnet, dass** sie ferner Folgendes umfasst:
- mehrere elektrische Leiter (48), die die Vorrichtung von einem Teil zum anderen ohne Verschweißung durchqueren, deren beiden Enden jeweils für einen direkten Kontakt mit den Anschlussbereichen (13) der beiden elektronischen Karten bestimmt sind,
- mechanische Mittel zum Halten der beiden elektronischen Karten an der Vorrichtung auf beiden Seiten davon,
- und dadurch, dass die Abschirmungsmittel durch ein Mikrowellenabsorptionsmittel (45) in Kontakt mit jedem Leiter (48) gewährleistet werden, das ihn über seine ganze Länge oder einen Teil seiner Länge umgibt.

2. Vorrichtung (40) zum Verbinden von zwei elektronischen Karten miteinander nach dem vorherigen Anspruch, **dadurch gekennzeichnet, dass** jeder elektrische Leiter (48) zwischen seinen beiden Enden Mittel zum Drücken seiner Enden zur Außenseite der Vorrichtung umfasst, um den elektrischen Kontakt mit den Anschlussbereichen zu verstärken.

3. Vorrichtung (40) zum Verbinden von zwei elektronischen Karten miteinander nach dem vorherigen Anspruch, **dadurch gekennzeichnet, dass** diese Druckmittel eine oder zwei mechanische Federn (44) oder Magnete sind, die elektrisch leitend zwischen den Enden platziert sind.

4. Vorrichtung (40) zum Verbinden von zwei elektronischen Karten miteinander nach einem der vorherigen Ansprüche, **dadurch gekennzeichnet, dass** die mechanischen Mittel zum Halten der zwei elektronischen Karten ein oder mehrere Gewindestäbe (41a) mit Muttern (41b) oder einer oder mehreren Schrauben umfassen.

5. Vorrichtung (40) zum Verbinden von zwei elektronischen Karten miteinander nach einem der vorherigen Ansprüche, **dadurch gekennzeichnet, dass** sie auf einer Fläche zum Kontaktieren einer Wand (32), die die Hohlräume begrenzt, eine elektromagnetische Dichtung (49) umfasst, die in einer Nut der Vorrichtung (47) vorzugsweise entfernbar angeordnet ist.

6. Vorrichtung (40) zum Verbinden von zwei elektronischen Karten miteinander nach einem der vorherigen Ansprüche, **dadurch gekennzeichnet, dass** sie ein Harz (46) zum Halten der Leiter in der Vorrichtung umfasst.

7. Vorrichtung (40) zum Verbinden von zwei elektronischen Karten miteinander nach einem der vorherigen Ansprüche, **dadurch gekennzeichnet, dass** das Mikrowellenabsorptionsmittel (45) Frequenzen über 1 GHz absorbiert.

8. Aktive RF-Ausrüstung, die Folgendes umfasst:
- zwei abgeschirmte Hohlräume (11, 21), die eine gemeinsame Trennwand (32) haben,
- zwei elektronische Karten (1, 2), wobei jede Karte in einem anderen abgeschirmten Hohlraum platziert ist, und
- eine Vorrichtung (40) zum Verbinden der zwei elektronischen Karten miteinander nach einem der vorherigen Ansprüche, installiert zwischen den zwei Hohlräumen in der gemeinsamen Trennwand.

## Claims

1. Device (40) for interconnecting two electronic cards (1, 2) each comprising electrical connection pads (13), each card being intended to be placed in a different sheathed cavity (11, 21), this device comprising inter-cavity hyperfrequency sheathing means, **characterised in that** it further comprises:
- a plurality of electrical conductors (48) which extend over the device from one side to the other, without welding, and whose two ends are intended to be in direct contact with the connection pads (13) of the two electronic cards, respectively,
- mechanical means for retaining the two electronic cards against the device, at one side and the other thereof,
- and **in that** the sheathing means are ensured by a hyperfrequency absorber (45) in contact with each conductor (48) and which surrounds it over all or part of the length thereof.

2. Device (40) for interconnecting two electronic cards according to the preceding claim, **characterised in that** each electrical conductor (48) comprises between the two ends thereof pressing means for the two ends thereof towards the outer side of the device in order to reinforce the electrical contact with the connection pads.

3. Device (40) for interconnecting two electronic cards according to the preceding claim, **characterised in that** these pressing means are one or two mechanical springs (44) or magnets which are electrically conductive and which are placed between the ends.

4. Device (40) for interconnecting two electronic cards according to any one of the preceding claims, **characterised in that** the mechanical means for retaining the two electronic cards comprise one (or more) threaded rod(s) (41a) with nuts (41b) or one (or more) screw(s).

5. Device (40) for interconnecting two electronic cards according to any one of the preceding claims, **characterised in that** it comprises, on a face which is intended to be in contact with a wall (32) which delimits the cavities, an electromagnetic sealing joint (49) which is arranged in a groove of the device (47) and which is preferably removable.

6. Device (40) for interconnecting two electronic cards according to any one of the preceding claims, **characterised in that** it comprises a resin (46) for retaining the conductors in the device.

7. Device (40) for interconnecting two electronic cards according to any one of the preceding claims, **characterised in that** the hyperfrequency absorber (45) is absorbent for frequencies greater than 1 GHz.

8. Active RF equipment which comprises:
- two sheathed cavities (11, 21) which comprise a common partition wall (32),
- two electronic cards (1, 2), each card being placed in a different sheathed cavity, and
- a device (40) for interconnecting the two electronic cards according to any one of the preceding claims, installed between the two cavities in the common partition wall.
